# EUROPEAN PATENT APPLICATION

(11) **EP 0 527 645 A1**
(43) Date of publication of application: **17.02.1993**
(21) Application number: 92307386.0
(22) Date of filing: 12.08.1992
(51) Int. Cl.: H01L 21/00

(54) **Apparatus for holding semiconductor devices during processing thereof**

(30) Priority: 12.08.1991 JP 226484/91
(71) Applicant: NEC CORPORATION, Tokyo (JP)
(72) Inventor: Nakano, Tosei, c/o NEC Corporation, Minato-ku, Tokyo (JP)
(74) Representative: Moir, Michael Christopher

(57) **Abstract**

A bonding metal bump forming apparatus for semiconductor devices is provided which comprises a stage having a wafer carrying surface, absorbing holes for absorbing a semiconductor wafer on the wafer carrying surface, the holes being formed in the wafer carrying surface so that a wafer of each size can be absorbed in at least the central area and peripheral area of the wafer, an absorbing hole selector for selectively connecting the absorbing holes to a vacuum source, and a bump forming apparatus for forming bonding metal bumps on each of the electrode pads of the wafer held on the wafer carrying surface by a vacuum absorptiom method. The bump formatiom can be carried out on various sizes of semiconductor wafers with a single stage. The absorbing holes are preferable to be formed concentrically annularly so as to use commonly one hole disposed in the innermost and to use the other holes exclusively for respective sizes of the wafers.

## Description

This invention relates to apparatus for holding semiconductor devices during processing, also to apparatus for producing semiconductor devices and more particularly, to an apparatus for holding or producing semiconductor devices, which has a stage on which a semiconductor wafer is held by a vacuum absorption method and processed. By "vacuum absorbtion method" we mean creating at least a partial vacuum between a carrying surface and the wafer, whereby the wafer is drawn onto the surface and held by atmospheric pressure acting on the wafer.

In a film carrier bonding semiconductor device or flip chip bonding semiconductor device, generally, metal bumps are formed respectively on electrode pads provided on an IC chip and then, the electrode pads are electrically bonded to a lead frame or the like utilizing the metal bumps thus formed. The metal bumps each is generally formed on the surface of an electrode pad so that a barrier layer composed of a diffusion preventing layer or connection layer is disposed on the electrode pad and a bonding metal such as gold (Au), solder and the like is formed through the barrier layer on the surface of the electrode pad by selectively performing an electrolytic plating method. However, many methods other than the electrolytic plating method are known. As an example, a "ball bump" method which. is disclosed in the Japanese Patent Laid-Open No. 49-52973 is known.

With the ball bump method thus disclosed, similar to the mire bonding method, the top end of a metal wire such as gold (Au), solder and the like is melted to make it ball-shaped , then bonded under the application of a pressure onto the corresponding one of electrode pads formed on a semiconducfor wafer and thereafter, the metal wire is cut so as to remain the ball-shaped metal or bump on the corresponding electrode pad surface. The ball bump method is generally applied for an automatic ball bump bonding apparatus.

In a conventional automatic ball bump bonding apparatus, a semiconducfor wafer having integrated circuits patterned is transferred from wafer supplying means into a bonding stage first, and placed on its wafer carrying surface. Next, a wafer holder, which is, for example, of a pawl-shaped type, is urged onto the side of the wafer with the orientation flat surface thereof as the reference thereby positioning the wafer in the horizontal direction on the wafer carrying surface. Subsequently, absorbing holes formed into the wafer carrying surface of the bonding stage are connected to a vacuum source thereby absorbing the wafer onto the wafer carrying surface with the help of a vacuum, thus finishing holding the wafer thereon. Then, ball bumps are formed respectively on the electrode pads formed on the wafer surface by the procedures as shown above. After finishing the formation of the ball bumps on all the electrode pads, the wafer is transferred into wafer containing means, The wafers thus contained thereinto are successively sent to the process for bonding the electrode pads respectively to the leads of a lead frame by utilizing the bumps thus formed.

In case of holding a semiconductor wafer by the vacuum absorption method, the wafer can be satisfactorily absorbed by applying a vacuum only in the central area thereof, however, in case of electrically connecting of the wafer by the ball bump bonding method, the application of a vacuum only in the central area is not acceptable. This is due to the fact that in case when the wafer is absorbed by applying a vacuum only in the central area thereof, it may be warped and as a result, there may generate a variation in bonding height (bump height), being largely apt to result in bonding failure. Thus, in case when ball bumps are to be formed by the ball bump bonding method, the wafer is required to be absorbed at least in the central and peripheral areas in order to prevent it from being warped.

On the other hand, semiconductor wafers are various in diametral size as 4, 5 and 6 inches. If the absorbing holes are formed in the wafer carrying surface of the bonding stage to be matched with a wafer having the largest possible diameter for bonding, in case when a wafer smaller in diameter than that wafer is to be bonded, there may remain some absorbing holes not to be closed by the wafer, resulting in the leakage of a vacuum, which means that the absorption force is not enough. In order to solve such problem, if the absorbing holes are formed so as to be matched with a wafer smaller in diameter than the largest one, the wafer will be largely apt to be warped as shown above.

In consideration of these points, in the conventional automatic ball bump bonding apparatus shown above, exclusively usable bonding stages are prepared in order to be matched with differently sized semiconductor wafers; each of which has absorbing holes formed so as to absorb the corresponding size of wafer in its central and peripheral areas thereof, so that the bonding process can be achieved by using an optimum bonding stage in accordance with the wafer size in diameter.

In this case, however, there arises such a problem that the bonding stage must be replaced with a different one whenever a wafer having a different size is to be bonded, that is, it is disadvantageously required to remove the stage from a base and to mount the different one thereonto with screws.

Thus, an object of this invention is to provide a holding device for use in apparatus for producing semiconductor devices, in which various sizes of semiconductor wafers can be held on a wafer carrying surface with no trouble by a vacuum absorption method.

Another object of this invention is to provide a bonding metal bump forming apparatus for producing semiconductor devices, in which bonding metal bumps can be formed on semiconductor wafers of various sizes with no trouble.

In a first aspect of this invention, an apparatus for holding a semiconductor wafer during processing thereof, comprises a wafer carrying surface on which the semiconductor wafer is held by a vacuum absorption method, (as hereinbefore defined),
a plurality of absorbing holes for absorbing a semiconductor wafer on said wafer carrying surface, said absorbing holes being formed in said wafer carrying surface so that semiconductor wafers of a plurality of sizes can be absorbed in at least the central area and peripheral area thereof; and
an absorbing hole selector for selectively connecting said absorbing holes to a vacuum source.

With the apparatus of this invention, the absorbing hole selector selects the desired absorbing hole or holes to be connected to a vacuum source in accordance with the size of a semiconductor wafer to be processed, so that even when the size of a wafer to be processed is changed, there does not need to replace the stage with one to be exclusively used as in the prior art. As a result, various sizes of semiconductor wafers can be held on the wafer carrying surface without generating any trouble by a vacuum absorption method.

The absorbing holes are not limited on shape, number and arrangement, if the vacuum absorption can be applied to a semiconductor wafer in at least the central and peripheral areas thereof in accordance with the size thereof. For example, one or two or more than two absorbing holes may be formed for this purpose.

Besides, the absorbing holes may be arranged arbitrarily. However, it is preferable that the absorbing holes each are annularly shaped and are concentrically arranged on the wafer carrying surface.

In this case, it is preferable that the absorbing holes include a first hole to be commonly used for respective sizes of wafers and at least one second hole to be exclusively used for respective sizes of wafers, and a semiconductor wafer of each size being absorbed by using the first and second holes.

In case that plural second holes are provided, the second holes may be used together with the first hole under the condition that the second holes to be used do not leak a vacuum in accordance with the size of semiconductor wafers.

The absorbing hole selector is not limited on its structure specifically, if it is possible to selectively connect the absorbing hole or holes to a vacuum source. However, the selector is preferably comprises at least one vacuum valve which opens or closes each of flow lines connected to the respective absorbing holes and a valve controller which controls the valve and selects the holes to be connected to a vacuum source.

In this case, the vacuum valve is preferably disposed in the stage and communicated through connecting flow lines formed in the stage with the respective absorbing holes.

The vacuum valve controller may comprise any means that can control the valve mechanically or electrically.

In addition, it is preferable that a sensor for detecting the size of a semiconductor wafer to be processed is provided and the absorbing hole selector is controlled in accordance with the size information obtained by the sensor to thereby selectively connecting the desired absorbing hole or holes to a vacuum source. In this case, even differently sized wafers can be continuously automatically processed using a single stage.

In a second aspect of this invention, there is provided processing apparatus for use in the manufacture of semiconductor devices comprising a holding apparatus as set forth above.

In particular the apparatus may be bump forming apparatus for producing semiconductor devices having a holding apparatus as aforesaid together with bump forming means for forming a bonding metal bump on each of the electrode pads of a semiconductor wafer held on the wafer carrying surface by a vacuum absorption method.

With the bonding metal forming apparatus of this invention, the absorbing hole or holes to be connected to a vacuum source can be selected in accordance with the size of a semiconductor wafer, so that the bonding bump formation on the electrode pads of differently sized semiconductor wafers can be achieved using a single stage. As a result, the apparatus of this aspect can provide us with such an effect that the bonding metal bump formation of differently shaped semiconductor wafers can be achieved without difficulty and without the need to substitute stages with holding surfaces of different sizes.

In this bump forming apparatus, the absorbing holes and the absorbing hole selector can be structured as in the first aspect of this invention. In addition, as in the first aspect, the desired absorbing hole or holes can be selected by a sensor for detecting the size of a semiconductor wafer and automatically connected to a vacuum source.

The bump forming means preferably forms bonding metal bumps by a ball bump method.

### BRIEF DESCRIPTION OF THE DRAWINGS

Fig. 1 is a perspective view of a ball bump forming apparatus on a semiconductor wafer according to one embodiment of this invention.

Fig. 2 is a schematic top view of a ball bump forming stage of the apparatus shown in Fig. 1.

Fig. 3 is a schematic sectional view of the ball bump forming stage shown in Fig. 2.

### DESCRIPTION OF THE PREFERRED EMBODIMENTS

One embodiment of this invention will be described below by referring to the drawings attached.

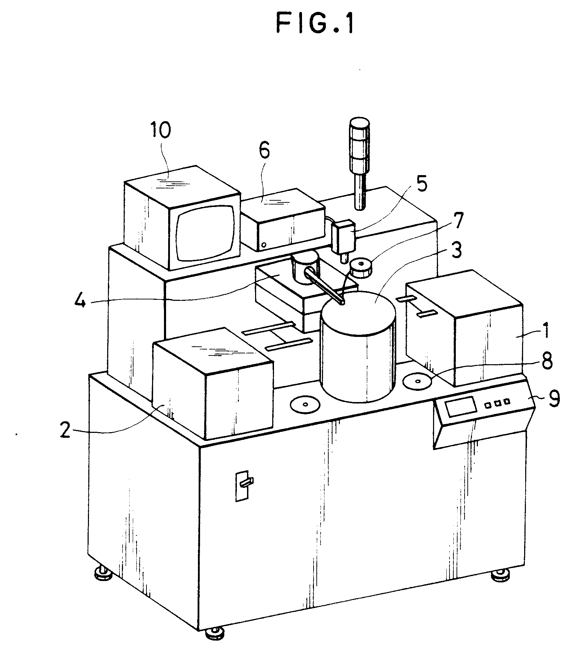

Fig. 1 is a ball bump forming apparatus on a semiconductor wafer according to one embodiment of this invention, which has wafer supplying section 1 for supplying semiconductor wafers on which ball bumps are to be formed, wafer containing section 2 for containing semiconductor wafers having ball bumps formed thereon, and a stage 3 which is disposed between the wafer supplying section 1 and the wafer containing section 2 for forming ball bumps on a semiconductor wafer placed thereon. The upper surface of the stage 3 is a wafer carrying surface for placing a semiconductor wafer and holding it by a vacuum absorption method.

A head 4 for forming bonding metal bumps on a wafer by a ball bump method is provided over the stage 3. A bonding metal wire is supplied from wire supplier 7 to the head 4.

A camera 5 for obtaining the pictorial image of a semiconductor wafer being held on the wafer carrying surface of the stage 3 is provided over the head 4. A recognition device 6 recognizes the position of a semiconductor wafer on the wafer carrying surface based on the image data obtained by the camera 5.

A manipulator 8 serves to move the stage 3 in the horizontal direction (in the X and Y directions) in accordance with the position of a wafer held on the wafer carrying surface of the stage 3.

The reference numerals 9 and 10 in Fig. 1 indicate an operation panel for controlling the apparatus and a monitor for monitoring the operation of the apparatus, respectively.

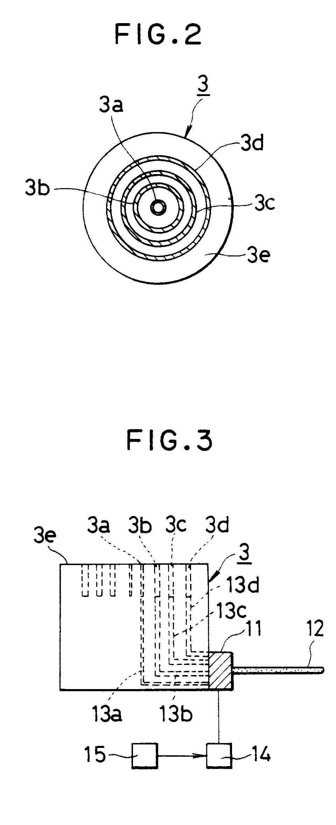

Figs. 2 and 3 illustrate in detail the structure of the stage 3 shown in Fig. 1. The stage 3 is substantially cylindrical in shape and has the wafer carrying surface 3e formed on its flat top surface. The flat wafer carrying surface 3e has, as shown in Fig. 2, four annular holes 3a, 3b, 3c and 3d formed for the vacuum absorption application. These holes 3a, 3b, 3c and 3d are arranged concentrically.

Besides, these holes 3a, 3b, 3c and 3d are, as shown in Fig. 3, formed in depth from the top surface 3e to about a half of the height of the stage 3 and connected to a vacuum valve 11 respectively through connecting flow lines 13a, 13b, 13c and 13d. To the vacuum valve 11, a conduit 12 connected to a vacuum source and a valve controller 14 are connected. To the valve controller 14 is sent the information on wafer size from a sensor 15 for detecting the size of a semiconductor wafer to be processed. The valve controller 14 serves to control the flow line of the vacuum valve 11 according to the size of a semiconductor wafer to be processed thereby selectively connecting the vacuum absorption holes 3a, 3b, 3c and 3d to the vacuum source.

The valve 11 has four flow lines which are connected respectively to the flow lines 13a, 13b, 13c and 13d and can be shut or communicated with the conduit 12 individually within the valve 11.

It may be provided with four valves for each of the lines 13a, 13b, 13c and 13d.

The hole 3a formed first from the center of the surface 3e is used in common to all sizes of semiconductor wafers and serves to absorb a semiconductor wafer in the central area thereof on the surface 3e. The hole 3b formed secondarily from the center of the surface 3e is to be used for a wafer with a diameter of four inches thereby to absorb it in the peripheral area thereof. The hole 3c formed thirdly from the center of the surface 3e is to be used for a wafer with a diameter of five inches to absorb in the peripheral area thereof. The hole 3d formed outermost from the center of the surface 3e is to be used for a wafer with a diameter of six inches to absorb in the peripheral area thereof.

As a result, a wafer with a diameter of four inches can be hold without being warped by connecting the holes 3a and 3b to the vacuum source, a wafer with a diameter of five inches can be held without being warped by connecting the holes 3a and 3c to the vacuum source, and a wafer with a diameter of six inches can be held without being warped by connecting the holes 3a and 3d to the vacuum source.

In addition, in case of processing a wafer with a diameter of six inches, all the holes 3a, 3b, 3c and 3d may be connected to the vacuum source because these holes 3a, 3b, 3c and 3d are closed by the wafer as clear from Fig. 2. Similarly, in case of processing a wafer with a diameter of five inches, the holes 3a, 3b and 3c may be connected to the vacuum source.

With the ball bump forming apparatus as shown above, a semiconductor wafer is transferred from the wafer supplying section 1 onto the stage 3 and placed on the wafer carrying surface 3e thereof. Next, the wafer thus placed thereon is positioned in a predetermined position by urging holding pawls onto the side surface thereof with an orientation flat surface of the wafer as the reference. Subsequently, the valve controller 14 is operated so that the flow lines connected to all or a part of the holes 3a, 3b, 3c and 3d can be automatically controlled and connected to the vacuum source.

The controlling operation at this time is carried out such that the holes 3a, 3b, 3c and 3d are selectively connected to the vacuum source so as to prevent the vacuum from being leaked and the wafer from being warped in accordance with the information on the wafer size sent from the sensor 15. Thus, the wafer can be held in position on the surface 3e of the stage 3.

The position of the wafer held on the surface 3e is recognized by the camera 5 and recognition device 6, and then, bonding metal bumps of gold, solder or the like are formed respectively on the electrode pads on the wafer in accordance with the coordinate information stored in the recognition device 6 in advance.

This formation of bumps is achieved by the ball bump method. Namely, first, the top end of a bonding metal wire continuously supplied from the wire supplier 7 to the head 4 is melted by applying a hydrogen flame to make it ball-shaped. Secondary, the ball-shaped top end of the wire is urged onto an electrode pad of the wafer heated at a predetermined temperature to be bonded thereto. Then, by applying a tension to the wire, the wire is cut while remaining the ball-shaped top end thereof on the electrode pad because the wire is softened by heating. Thus, the bonding metal bump is formed on the electrode pad.

This bump forming process is repeated until the bonding metal bumps are formed on all the electrode pads of the wafer. Then, the wafer thus processed is sent to the wafer containing section 2. Subsequently, the bonding of the electrode pads to leads is performed automatically using the bumps thus formed on the electrode pads.

In this embodiment, the explanations were made on a ball bump forming apparatus, but this invention can be applied for any apparatus for producing semiconductor devices including a process which requires to absorb a semiconductor wafer by applying a vacuum so as not to be warped, for example, for a wafer polishing apparatus for polishing the surface of a semiconductor wafer, a resist exposure apparatus for exposing a resist film coated on the surface of a semiconductor wafer and the like.

As described above, with the apparatus according to the embodiment of this invention, there does not need to change the stage even if the diameter of a semiconductor wafer to be processd is changed, so that the steps to be carried out can be reduced in number as well as can be achieved automatically.

## Claims

1. An apparatus for holding a semiconductor wafer during processing thereof, comprising a wafer carrying surface on which the semiconductor wafer is held by a vacuum absorption method, (as hereinbefore defined),
a plurality of absorbing holes for absorbing a semiconductor wafer on said wafer carrying surface, said absorbing holes being formed in said wafer carrying surface so that semiconductor wafers of a plurality of sizes can be absorbed in at least the central area and peripheral area thereof; and
an absorbing hole selector for selectively connecting said absorbing holes to a vacuum source.

2. The apparatus as claimed in Claim 1, wherein each of said absorbing holes is an annular hole.

3. The apparatus as claimed in Claim 2, wherein said annular absorbing holes are concentrically arranged on said wafer carrying surface.

4. The apparatus as claimed in Claim 3, wherein said absorbing holes include a first hole to be commonly used for all sizes of semiconductor wafers and at least one second hole of a diameter to absorb a specific size of semiconductor wafer adjacent the periphery thereof.

5. The apparatus as claimed in Claim 4, wherein a plurality of said second holes are provided, said second holes being used together with said first hole and the selector such that said second holes to be used do not leak a vacuum in accordance with the size of semiconductor wafers.

6. The apparatus as claimed in any preceding claim, wherein said absorbing hole selector comprises at least one vacuum valve which opens or closes each of flow lines connected to said respective absorbing holes and a valve controller which controls said valve and selects said holes to be connected to a vacuum source.

7. The apparatus as claimed in Claim 6, wherein said vacuum valve is disposed in a stage supporting the wafer carrying surface and communicates through connecting flow lines formed in said stage with said respective absorbing holes.

8. The apparatus as claimed in any preceding claim, wherein a sensor for detecting the size of a semiconductor wafer to be processed is provided and said absorbing hole selector is controlled in accordance with the size information obtained by said sensor to thereby selectively connecting said desired absorbing hole or holes to a vacuum source.

9. Processing apparatus for use in the manufacture of semiconductor devices comprising a holding apparatus as claimed in any preceding claim.

10. A bonding metal bump forming apparatus for semiconductor devices comprising holding apparatus as claimed in any of Claims 1 to 8, and bump forming means for forming bonding metal bumps on each of electrode pads of a wafer held on said wafer carrying surface.

11. The apparatus as claimed in Claim 10, wherein said bump forming means forms bonding metal bumps by a ball bump method.
